# EUROPEAN PATENT APPLICATION

(11) **EP 2 743 709 A1**
(43) Date of publication of application: **18.06.2014**
(21) Application number: 12196592.5
(22) Date of filing: 11.12.2012
(51) Int. Cl.: G01R 13/02, G01R 23/16, G01R 23/18

(54) **Real time spectrum analyzer with zoom display**

(71) Applicant: Tektronix Inc., Beaverton Oregon 97077-0001 (US)
(72) Inventor: Earls, Jeffrey, Portland, OR Oregon 97229 (US); Borden, Franklin, Sherwood, OR Oregon 97140 (US); Garrison, Kelly, Tigard, OR Oregon 97224 (US)
(74) Representative: Clarke, Jeffrey

(57) **Abstract**

The described test and measurement instrument includes a processor for generating a bitmap image (412) from an input test signal, a user interface for identifying a portion (420) of the bitmap image, and a second image generator structured to generate a second image (432) from the identified portion of the bitmap image. The second image may be a zoomed image from the original bitmap, and the images may be time-corrected before being displayed.

## Description

### FIELD OF THE INVENTION

This disclosure is directed toward test and measurement instruments, and, more particularly, to a frequency domain bitmap having a zoom display.

### BACKGROUND

Real-time spectrum analyzers such as the RSA6100, RSA5100, and RSA3400 families available from Tektronix, Inc. of Beaverton, Oregon trigger on, capture, and analyze RF signals in real-time. These test and measurement instruments seamlessly capture RF signals so that, unlike conventional swept spectrum analyzers and vector signal analyzers, no data is missed within a specified bandwidth.

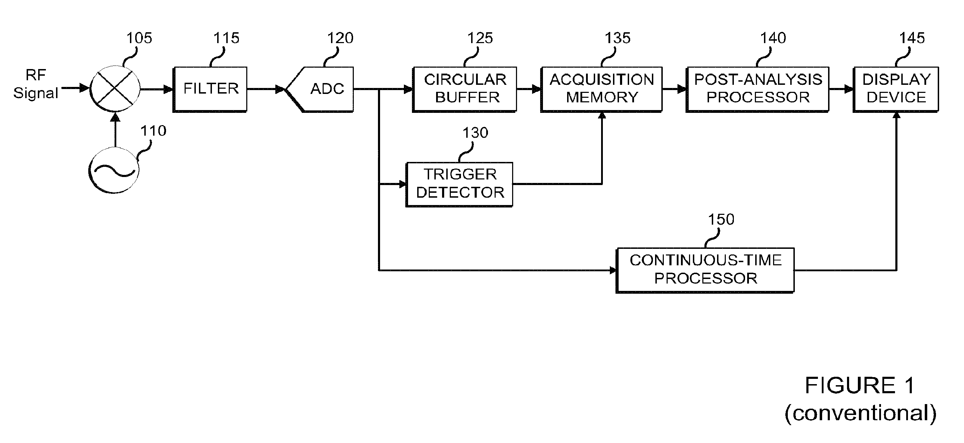

Referring now to FIG. 1, a real-time spectrum analyzer 100 receives a radio frequency (RF) input signal and optionally down-converts it using a mixer 105, local oscillator (LO) 110, and filter 115 to produce an intermediate frequency (IF) signal. An analog-to-digital converter (ADC) 120 digitizes the IF signal to produce a continuous stream of digital samples. The digital samples are input to a circular buffer 125 and also input to a trigger detector 130 that processes the digital samples in real-time and compares the processed samples to a user-specified trigger threshold. When the processed digital samples violate the trigger threshold, the trigger detector 130 generates a trigger signal that causes an acquisition memory 135 to store the digital samples held in the circular buffer 125. "Violate" means either "exceeds" or "is less than," depending on a user-specified parameter. The stored digital samples are then analyzed by a post-analysis processor 140, and the results may be displayed on a display device 145 or stored in a storage device (not shown).

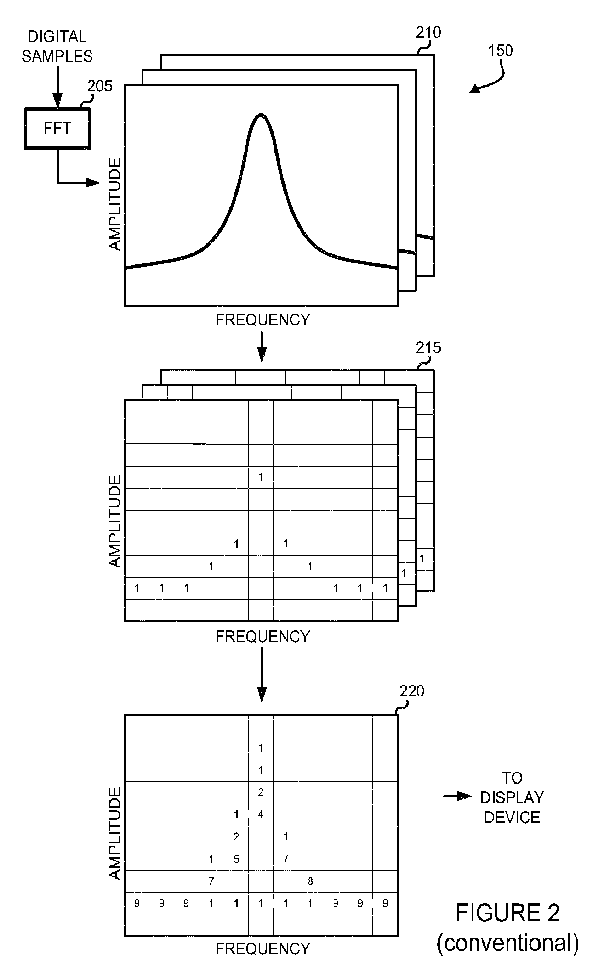

Tektronix real-time spectrum analyzers use a technology referred to as "Digital Phosphor" or alternatively as "DPX.RTM.." A DPX-enabled real-time spectrum analyzer uses a continuous-time processor 150 to process the continuous stream of digital samples from the ADC 120 in real-time and display the results on the display device 145. Referring now to FIG. 2, the continuous-time processor 150 uses a frequency transform 205 such as a fast Fourier transform (FFT), a chirp-Z transform, or the like to transform the continuous stream of digital samples into thousands of spectra 210 every second. The spectra 210 are then combined to form a data structure referred to as a "bitmap database" 220. In one embodiment, each spectrum 210 is rasterized to produce a "rasterized spectrum" 215. A rasterized spectrum comprises an array of cells arranged in of a series of rows and columns, with each row representing a particular amplitude value and each column representing a particular frequency value. The value of each cell is either a "1," also referred to as a "hit," which indicates that the input signal was present at that particular location in the amplitude versus frequency space during the measurement period, or a "0" (depicted as a blank cell in the Drawings), which indicates that it was not. The values of the corresponding cells of the rasterized spectra 215 are summed together to form the bitmap database 220, and then the value of each cell of the bitmap database 220 is divided by the total number of rasterized spectra 215 so that it indicates the total number of hits during the measurement period divided by the total number of rasterized spectra 215, or equivalently, the percentage of time during the measurement period that the input signal occupied that particular location in the amplitude versus frequency space, also referred to as the "DPX Density.RTM.." The rasterized spectra 215 and the bitmap database 220 are depicted in the Drawings as having 10 rows and 11 columns for simplicity, however it will be appreciated that in an actual embodiment, the rasterized spectra 215 and the bitmap database 220 may have hundreds of columns and rows. The bitmap database 220 is essentially a three-dimensional histogram, with the x-axis being frequency, the y-axis being amplitude, and the z-axis being density. The bitmap database 220 may be displayed as an image referred to as a "bitmap" on the display device 145, with the density of each cell being represented by a color-graded pixel. Alternatively, the bitmap database 220 may be stored in a storage device (not shown). DPX acquisition and display technology reveals signal details such as short-duration or infrequent events that are completely missed by conventional spectrum analyzers and vector signal analyzers. For more information on DPX, see Tektronix document number 37W-19638 titled "DPX.RTM. Acquisition Technology for Spectrum Analyzers Fundamentals" dated Aug. 20, 2009, available at http://www.tek.com/.

With this background, the advantages and other novel features of the present invention are apparent from the following detailed description when read in conjunction with the appended claims and attached drawings.

### SUMMARY OF THE INVENTION

A width of a typical final display of DPX spectrum is limited by a number of pixels making up the display. For example, a typical DPX spectrum is 768 or 800 pixels wide, and this width may be limited by hardware considerations, display limitations, or both. Unfortunately, when viewing a very wide frequency span using the entire display width of approximately 800 pixels, each pixel width conveys a large component frequency, and important signals may be missed. For example, a 2GHz display on a 768 pixel-wide DPX spectrum allows a 3.48 MHz wide W-CDMA signal only 2 pixel-widths of display. Sometimes this means that relevant signal detail is lost in the DPX spectrum, due to the vast amount data being shown on the display.

Embodiments of the invention address such limitations by producing a second, user-controlled, DPX spectrum highlighting areas of interest of the primary DPX spectrum. Then, both the primary and secondary DPX spectrums are shown simultaneously.

Accordingly, embodiments of the invention includes a processor for generating a bitmap image from an input test signal, a user interface for identifying a portion of the bitmap image, and a second image generator structured to generate a second image from the identified portion of the bitmap image. The same input test signal may be used to generate the bitmap image and the second image. Further, the bitmap image and the second image may be simultaneously shown on the display. In some embodiments the test signal is downconverted and filtered before the second image is generated from it. In most embodiments the bitmap image and the second image are corrected for time alignment. The user interface allows a user to select a beginning and end portion of the bitmap image for generation as the second image. In further embodiments, a third bitmap image may be created, from a user specified portion of either the original bitmap image or the second bitmap.

Other embodiments include a method for generating bitmapped images from a signal for testing. After a first bitmapped image of the signal for testing is generated, a user specifies a portion of the first bitmapped image. Then a second bitmapped image is generated encompassing the portion of the first bitmapped image. In some embodiments the second bitmapped image is generated from the signal for testing. In some embodiments the first bitmapped image and the second bitmapped image are then simultaneously displayed. In further embodiments a third bitmapped image is made encompassing either a portion of the second bitmapped image, or encompassing a second portion of the first bitmapped image.

### BRIEF DESCRIPTION OF THE DRAWINGS

Fig. 1 is a functional block diagram of a conventional real-time spectrum analyzer.

Fig. 2 is a functional block diagram illustrating operation of the continuous-time processor component illustrated in Fig.l.

Fig. 3 is a screen shot of a conventional DPX spectrum.

Fig. 4 is a diagram that includes both a primary and a secondary DPX spectrum according to embodiments of the invention.

Fig. 5 is a functional block diagram of components of a spectrum analyzer including a secondary DPX processor according to embodiments of the invention.

Fig. 6 is an example flow diagram illustrating methods according to embodiments of the invention.

Fig. 7 is a block diagram illustrating an embodiment of the invention including two secondary spectrums generated from a primary spectrum.

Fig. 8 is a block diagram illustrating another embodiment of the invention that includes two secondary spectrums generated from a primary spectrum.

Fig. 9 is a block diagram illustrating an embodiment of the invention that includes a primary, a secondary, and a tertiary spectrum.

### DETAILED DESCRIPTION

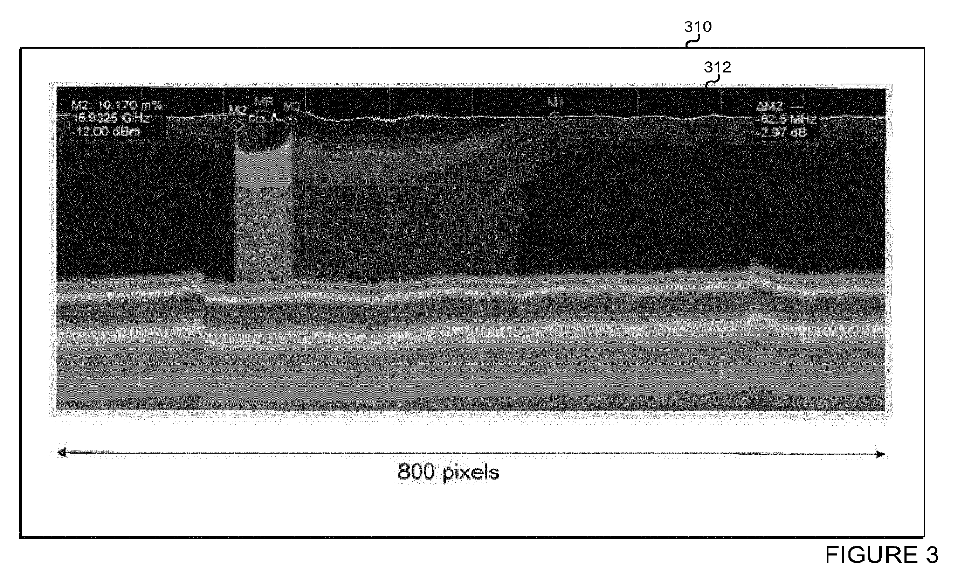

Fig. 3 is a screen shot of a conventional DPX spectrum 312 that may be generated by the system described above. The DPX spectrum 312 is shown as displayed on a display 310, which may be a conventional display for test and measurement equipment, such as LCD (Liquid Crystal Display), etc. The display 312 may be part of a test and measurement device, or may be separate.

As described above, the DPX spectrum 312 shows data from the sampled test signal as different colored pixels on the display 310, illustrated in Fig. 3 as greyscale. Sometimes hardware limits of the display or, more typically, the processor that generates the bitmap image, for example the bitmap database 220 of Fig. 2, limits the width of the DPX spectrum ultimately shown on the display. For example, the DPX spectrum 312 in Fig. 3 is approximately 800 pixels wide.

Having a limited number of pixels as the width for a DPX spectrum forces each pixel-width of the DPX spectrum to convey a large amount of information, and the information may be lost or unperceivable on the display 310. This is especially true when the signal under test is a broadband signal. For example, if the test signal for a real-time DPX spectrum is 2GHz, and if a DPX spectrum is 768 pixels wide, a 3.48 MHz wide CDMA signal portion of the 2GHz is displayed in only two pixel-widths. This may not be enough width on the DPX spectrum to allow a user sufficient screen area on which to view important data. Or, stated differently, the DPX spectrum may be so compressed that important signals are hard to discern from all the other data being displayed.

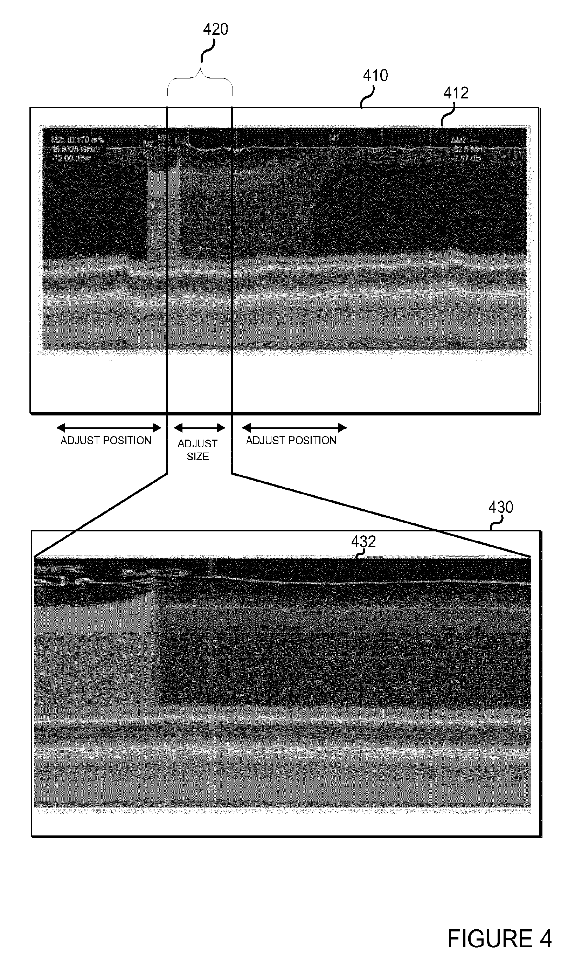

Fig. 4 is a diagram that includes both a primary 412 and a secondary 432 DPX spectrum according to embodiments of the invention. In this example, the primary DPX spectrum 412 is the same as the DPX spectrum 312 of FIG. 3. A portion 420 of the primary DPX spectrum 412 is selected by a user as an area of the spectrum in which the user would like more detail. Therefore, when a zoom mode is activated, a secondary DPX spectrum 432 is generated and shown on the display 430 that shows additional detail of the portion 420 of the primary DPX spectrum 412. Importantly, in some embodiments, the secondary DPX spectrum 432 is not merely a larger version of the portion 420 of the primary DPX spectrum, but rather the secondary DPX spectrum 432 is generated by a separate DPX processor, from the original test signal data, as described in detail below. This effectively allows the user to obtain more detail from the test and measurement instrument.

In some embodiments the width of the portion 420 of the primary DPX spectrum is adjustable by user action, such as by expanding a window edge, or other common display manipulations. In other embodiments the user selects a mid-point of the portion 420 as well as a width of the window to select the portion of the DPX spectrum to examine in detail.

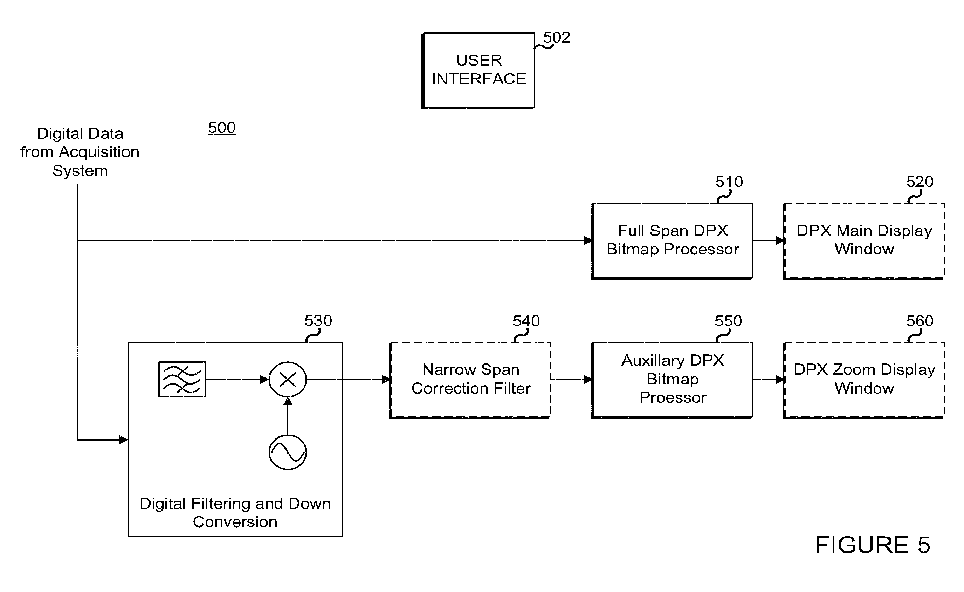

Fig. 5 is a functional block diagram of components of a spectrum analyzer including a secondary DPX processor according to embodiments of the invention. A test and measurement instrument according to embodiments of the invention includes a processor, such as a full span DPX bitmap processor 510 for generating a bitmap image from an input test signal. The DPX bitmap generated from the processor 510 includes the full width of the test signal. The full scan DPX bitmap is presented in display window 520, which may be shown on a display that may or may not be part of the test and measurement instrument.

A user interface 502 is controlled by the user to identify a portion of the bitmap image about which the user would like more information. As described above, the user interface may allow the user to select particular portions of the full scan DPX bitmap to be displayed in a secondary window or on a secondary display.

A second image generator, such as the secondary DPX bitmap processor 550, generates a second image in a display window 560 that includes the identified portion of the original bitmap image generated by the full scan processor 510. Note that such a system, such as the one illustrated in Figure 5, uses the same base data to generate both the original bitmap image from the processor 510 and the secondary bitmap image from the processor 550. Additional processing such as downprocessing and filtering may be performed on the original data acquired from the acquisition system prior to sending it to the second image generator, such as the secondary DPX bitmap processor 550. Primary filtering and down conversion may occur in a downconverter 530, and an optional narrow span correction filter 540 may also be present in the system.

Before being displayed on the main window 520 and secondary, or zoom window 560, the primary and secondary DPX bitmaps are corrected for time alignment.

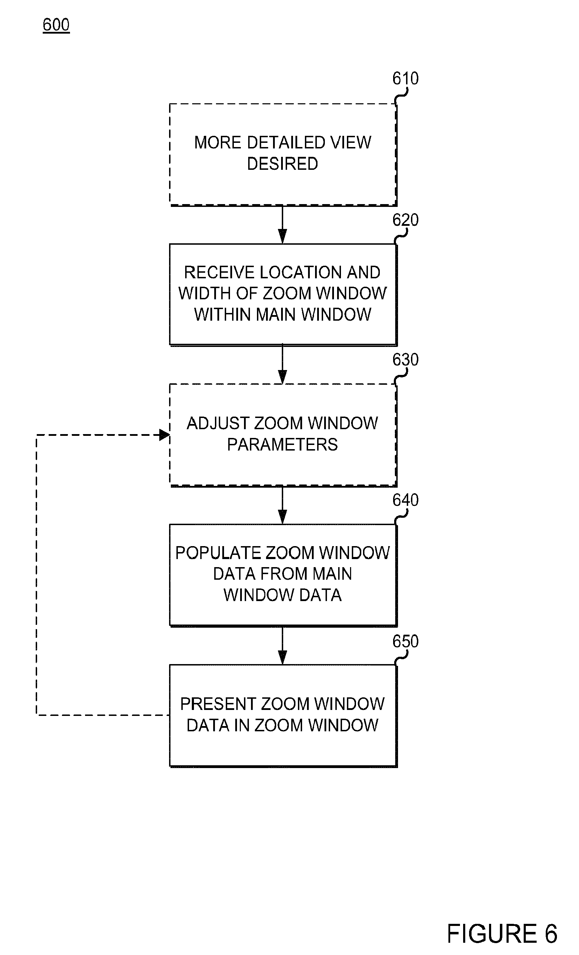

Fig. 6 is an example flow diagram illustrating methods according to embodiments of the invention. A signal is accepted for testing and a first bitmapped image of the signal is generated. In a process 610, the flow 600 receives input that a more detailed view is desired by the user. This may be generated by, for instance, a user selecting a zoom process or opening a zoom window on a test and measurement instrument. In a process 620, input is accepted from a user input, which may include, for example, a width and location that specifies a portion of the first bitmapped image for which a zoom window is to be generated. Then a zoom window is generated from the same data that generated the original bitmapped image in a process 640, and displayed to the user in a process 650. The generated second bitmapped image encompasses the portion of the first bitmapped image that the user specified in the process 620.

In some embodiments, as illustrated in Fig. 4, the first and second bitmapped images are time-aligned and simultaneously displayed. As described above, the second bitmapped image may be downconverted and filtered before it is generated.

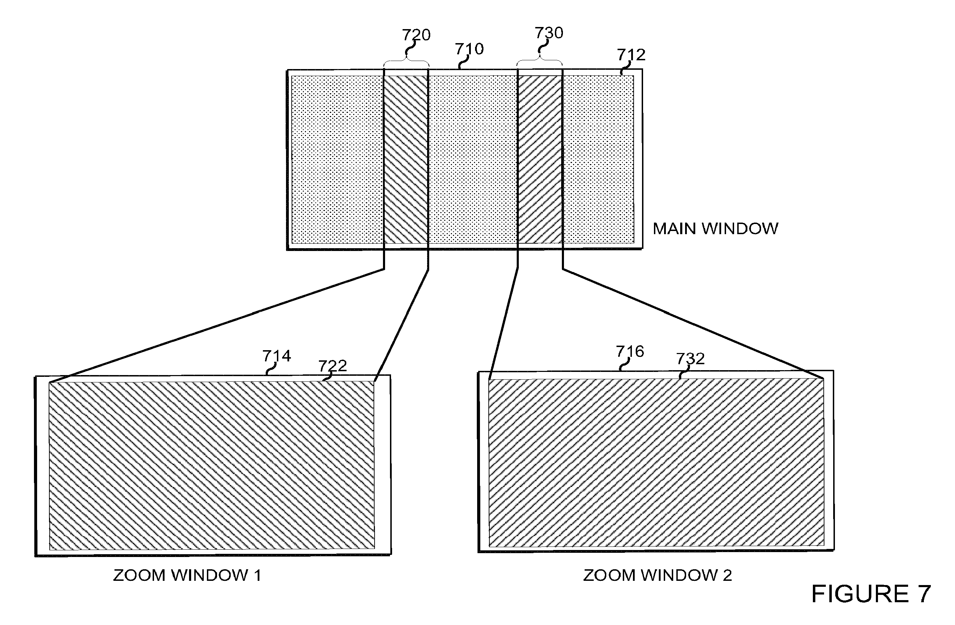

Fig. 7 is a block diagram illustrating an embodiment of the invention including two secondary spectrums, or zoom windows, generated from a primary spectrum, illustrated here. Fig. 7 is similar to that of Fig.4, except that two zoom windows 722, 732 are generated, respectively from two portions 720, 730 of a display 712 on the main window 712. The two zoom windows 722, 732 may be generated as described above with reference to a single zoom window, however, a third bitmap processor may be used, in parallel with the primary and secondary processors 510, 550 of Fig. 5.

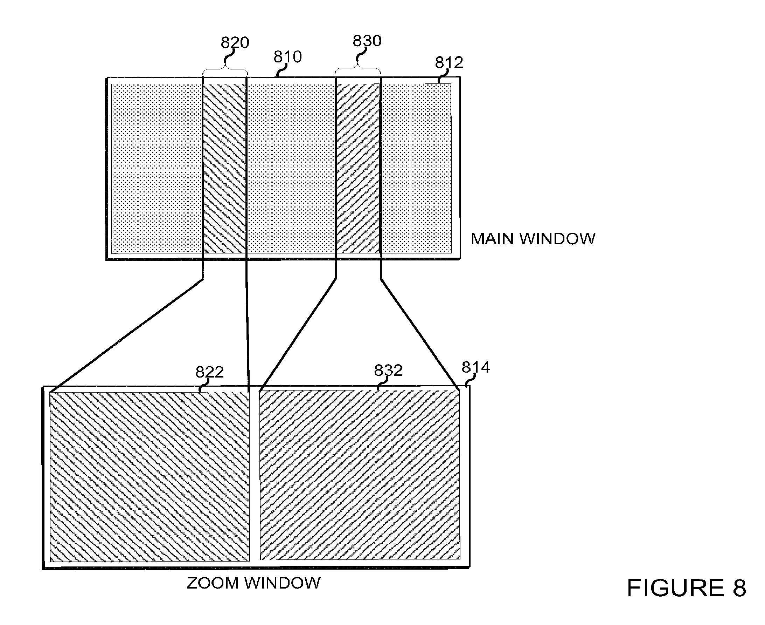

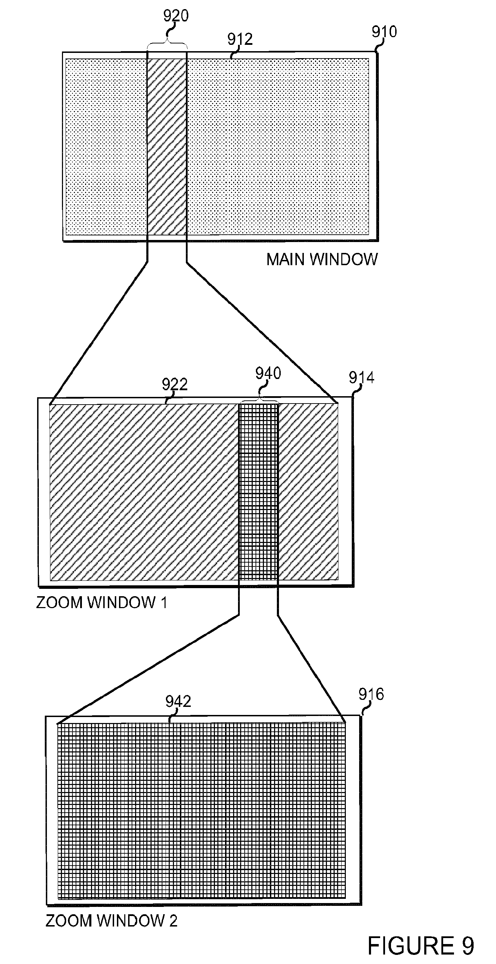

Fig. 8 is a block diagram illustrating another embodiment of the invention that includes two secondary spectrums generated from a primary spectrum. This embodiment is similar to the one illustrated in Fig. 7, however the two zoom windows 822, 832, are shown on a single display 814. Finally, as illustrated in Fig. 9, a system may include a zoom window 922 that is a more detailed view of the portion 920 of the original main window, as well as a second zoom window 942 that is a more detailed view of the portion 940 of the first zoom window 922. These windows may also be referred to a primary, secondary, and tertiary windows.

Although many of the embodiments described above include a user interface, it will be appreciated that in other embodiments, those parameters may alternatively be determined automatically by a test and measurement instrument

Although the embodiments illustrated and described above show the present invention being used in a real-time spectrum analyzer, it will be appreciated that embodiments of the present invention may also be used advantageously in any kind of test and measurement instrument that displays frequency domain signals, such as a swept spectrum analyzer, a signal analyzer, a vector signal analyzer, an oscilloscope, and the like.

In various embodiments, components of the invention may be implemented in hardware, software, or a combination of the two, and may comprise a general purpose microprocessor, a digital signal processor (DSP), an application specific integrated circuit (ASIC), a field-programmable gate array (FPGA), or the like.

It will be appreciated from the forgoing discussion that the present invention represents a significant advance in the field of displays for frequency domain bitmaps. Although specific embodiments of the invention have been illustrated and described for purposes if illustration, it will be understood that various modifications may be made without departing from the scope of the invention. Accordingly, the invention should not be limited except as by the appended claims.

The following section of the description consists of numbered paragraphs simply providing statements of the invention already described herein. The numbered paragraphs in this section are not claims. The claims are set forth below in the later section headed "claims".

A test and measurement instrument comprising:
a processor for generating a bitmap image from an input test signal;
a user interface for identifying a portion of the bitmap image; and
a second image generator structured to generate a second image that includes the identified portion of the bitmap image.

The test and measurement instrument of any of [0037], in which the input test signal is used to generate the bitmap image and the second image.

The test and measurement instrument of any of [0037] - [0038], further comprising a display, and in which the bitmap image and the second image are simultaneously shown on the display.

The test and measurement instrument of any of [0037] - [0039], further comprising a downconverter, and in which the test signal is downconverted before the second image is generated.

The test and measurement instrument of any of [0037] - [0040], further comprising a narrow span correction filter, and in which the downconverted test signal is filtered through the narrow span correction filter prior to being passed to the second image generator.

The test and measurement instrument of any of [0037] - [0041], in which the bitmap image and the second image are corrected for time alignment.

The test and measurement instrument of any of [0037] - [0042], in which the user interface is structured to allow a user to select a beginning and end portion of the bitmap image for generation as the second image.

The test and measurement instrument of any of [0037] - [0043], in which the user interface allows a user to identify a second portion of the bitmap image, and further comprising a third image generator structured to generate a third image from the second portion of the bitmap image.

The test and measurement instrument of any of [0037] - [0044], in which the user interface allows a user to identify a portion of the second image, and further comprising a third image generator structured to generate a third image from the identified portion of the second image.

A method in a test and measurement device, comprising:
accepting a signal for testing;
   generating a first bitmapped image of the signal for testing;
accepting user input specifying a portion of the first bitmapped image; and
   generating a second bitmapped image encompassing the portion of the first bitmapped image.

The method of [0046], in which generating a second bitmapped image comprises generating a second bitmapped image from the signal for testing.

The method of any of [0046] - [0047], further comprising:
simultaneously displaying the first and second bitmapped images.

The method of any of [0046] - [0048], further comprising time-aligning the first bitmapped image and the second bitmapped image before simultaneously displaying the first and second bitmapped images.

The method of any of [0046] - [0049], further comprising downconverting the signal for testing.

The method of any of [0046] - [0050], further comprising filtering the downconverted signal.

The method of any of [0046] - [0051], in which the user input specifies a beginning and an end of the portion of the first bitmapped image.

The method of any of [0046] - [0052], further comprising:
accepting user input specifying a second portion of the first bitmapped image; and
generating a third bitmapped image encompassing the second portion.

The method of any of [0046] - [0053], further comprising:
accepting user input specifying a portion of the second bitmapped image; and
generating a third bitmapped image encompassing the portion of the second bitmapped image.

## Claims

1. A test and measurement instrument comprising:
a processor for generating a bitmap image from an input test signal;
a user interface for identifying a portion of the bitmap image; and
a second image generator structured to generate a second image that includes the identified portion of the bitmap image.

2. The test and measurement instrument of claim 1, in which the input test signal is used to generate the bitmap image and the second image.

3. The test and measurement instrument of claim 1 further comprising a display, and in which the bitmap image and the second image are simultaneously shown on the display.

4. The test and measurement instrument of claim 1 further comprising a downconverter, and in which the test signal is downconverted before the second image is generated.

5. The test and measurement instrument of claim 4, further comprising a narrow span correction filter, and in which the downconverted test signal is filtered through the narrow span correction filter prior to being passed to the second image generator.

6. The test and measurement instrument of claim 1, in which the bitmap image and the second image are corrected for time alignment.

7. The test and measurement instrument of claim 1, in which the user interface is structured to allow a user to select a beginning and end portion of the bitmap image for generation as the second image.

8. The test and measurement instrument of claim 1, in which the user interface allows a user to identify a second portion of the bitmap image, and further comprising a third image generator structured to generate a third image from the second portion of the bitmap image.

9. The test and measurement instrument of claim 1, in which the user interface allows a user to identify a portion of the second image, and further comprising a third image generator structured to generate a third image from the identified portion of the second image.

10. A method in a test and measurement device, comprising:
accepting a signal for testing;
generating a first bitmapped image of the signal for testing;
accepting user input specifying a portion of the first bitmapped image; and
generating a second bitmapped image encompassing the portion of the first bitmapped image.

11. The method of claim 10, in which generating a second bitmapped image comprises generating a second bitmapped image from the signal for testing.

12. The method of claim 10, further comprising:
simultaneously displaying the first and second bitmapped images.

13. The method of claim 12, further comprising time-aligning the first bitmapped image and the second bitmapped image before simultaneously displaying the first and second bitmapped images.

14. The method of claim 10, further comprising downconverting the signal for testing.

15. The method of claim 10, further comprising filtering the downconverted signal.
